# EUROPÄISCHE PATENTSCHRIFT

(11) **EP 0 308 667 B1**
(45) Veröffentlichungstag und Bekanntmachung des Hinweises auf die Patenterteilung: **25.05.1994**
(21) Anmeldenummer: 88113725.1
(22) Anmeldetag: 23.08.1988
(51) Int. Cl.: H01L 29/10, H01L 29/73, H01L 29/74

(54) **Absaugelektrode zur Verkürzung der Ausschaltzeit bei einem Halbleiterbauelement**
Extraction electrode to lower the turn-off time of a semiconductor device
Electrode d'extraction pour diminuer le temps d'extinction d'un dispositif semi-conducteur

(30) Priorität: 23.09.1987 DE 3732074
(43) Veröffentlichungstag der Anmeldung: 29.03.1989
(73) Patentinhaber: SIEMENS AKTIENGESELLSCHAFT, 80333 München (DE)
(72) Erfinder: Dathe, Joachim, Dipl.-Phys., D-8000 München 40 (DE); Deckers, Margarete, Dipl.-Phys., D-8000 München 90 (DE)

(56) Entgegenhaltungen:
- EP-A- 0 014 098
- EP-A- 0 231 895
- DE-A- 2 714 886
- GB-A- 1 319 037
- US-A- 3 510 735
- IEEE TRANSACTIONS ON ELECTRON DEVICES, Band ED-23, Nr. 8, August 1976, Seiten 883-887, IEEE, New York, US; S. SHIMIZU et al.: "High-voltage high-power gate-assisted turn-off thyristor for high-frequency use"

## Beschreibung

Die Erfindung betrifft einen Schalttransistor mit einer Absaugelektrode zur Verkürzung der Ausschaltzeit nach dem Oberbegriff des Anspruchs 1.

Die Erfindung befaßt sich mit der Herstellung von Schalttransistoren. Zur Zeit wird bei Schalttransistoren eine kurze Schaltzeit durch eine gezielte Gold-(Au)-Verunreinigung erzielt. Infolge der Verunreinigung mit Gold wird die Schaltzeit durch eine Erhöhung der Rekombinationsrate der Ladungsträger im Halbleiterkristall gesenkt.

Dieses bekannte Verfahren, die Schaltzeit durch eine gezielte Gold-Verunreinigung zu verkürzen, hat folgende Nachteile:
Bei der Herstellung von Halbleiterscheiben werden zusätzliche Technologieschritte, z.B. für die Gold-Verunreinigung, benötigt; die Gold-Verunreinigung bewirkt eine starke Senkung der Stromverstärkung des Halbleiterbauelements und infolgedessen einen nicht-linearen Verlauf dieser Stromverstärkung in Abhängigkeit vom Kollektorstrom, eine Erhöhung der Dioden-Sperrströme und eine Erhöhung des Rauschfaktors; weil die Eigenschaften des Ausgangsmaterials bei der Herstellung von Halbleiterbauelementen schwanken können und weil auch Prozeßparameter beim Herstellungsprozeß für die Halbleiterbauelemente gewissen Schwankungen unterliegen können, können sich Unterschiede in der Getterung der Gold-Verunreinigungen ergeben und können damit schwankende Schaltzeiten, schwankende Stromverstärkungen, unterschiedliche Sperrströme und unterschiedliches Rauschverhalten der in dieser Weise hergestellten Transistoren auftreten.

Zur Vermeidung dieser bekannten Nachteile wurde bereits vorgeschlagen, zusätzliche Emitter-Diffusionsgebiete im Bereich der Basis vorzusehen, welche mit der Basis metallisch kurzgeschlossen sind und beim Umschalten der Emitter-Basis-Diode von Flußrichtung in Sperrichtung die Basis-Minoritätsladungsträger "absaugen".

In folgenden Veröffentlichungen wurden bereits zusätzliche Diffusionsgebiete im Basisbereich beschrieben:
1) J. Narian, IEEE El. Dev. Let., Vol. ED-6, No. 11, November 1985,
2) M. Conti et al., DE-C-28 02 799,
3) G. B. Potter, US-A-3 510 735.

Die aus diesen drei genannten Veröffentlichungen bekannten zusätzlichen Emitter-Diffusionsgebiete sind im wesentlichen durch folgende Punkte charakterisiert:

Bei den Veröffentlichungen 1) und 2) ist der Bereich der Zusatzdiffusion ganzflächig mit dem Basisbereich metallisch kurzgeschlossen, dies bedeutet, daß das Metall den Oberflächen-pn-Übergang von dem Zusatz-Diffusionsbereich und dem Basis-Bereich überlappt. Dies bewirkt folgende Nachteile: Der pn-Übergang von Zusatzdiffusions-Bereich und Basis-Bereich wird überall an der Oberfläche des Halbleiterbauelements über ein Metall kurzgeschlossen. Die für die Absaug-Wirkung des Zusatzdiffusions-Bereichs wichtige Diffusionsspannung kann an der Oberfläche des Halbleiterbauelements, wo sie aufgrund des Dotier-Profils ohne metallischen Kurzschluß zwischen Zusatzdiffusions-Bereich und Basis-Bereich am größten wäre, nicht voll wirksam werden. Der von der Zusatzdiffusion hervorgerufene Absaugeffekt für die Minoritätsladungen im Basisbereich ist an der Oberfläche des Halbleiterbauelements infolgedessen begrenzt.

Außerdem wird bei den aus den Veröffentlichungen 1) und 2) bekannten Transistoren erheblich mehr Platz bei Anwendung des Zusatzdiffusionsbereichs benötigt, weil zwischen der Basismetallisierung und der Emittermetallisierung ein bestimmter Abstand erforderlich ist.

Bei der Veröffentlichung 3) ist der Zusatzdiffusions-Bereich als Pinch-Widerstand um den Basisanschluß herum angeordnet und hat einen großen Abstand zum Emitterbereich. Infolge diesen großen Abstandes zum Emitterbereich kann das Zusatzdiffusions-Gebiet die Minoritätsladungsträger nicht aus der effektiv wirksamen Basis unter dem Emitterbereich absaugen. Das Zusatzdiffusionsgebiet ist daher in seiner Wirkung als Diffusionssenke eingeschränkt.

Auch bei der Veröffentlichung 3) besteht ein erhöhter Platzbedarf, weil für das Zusatzdiffusionsgebiet ein zusätzlicher Platz benötigt wird.

Bei der Veröffentlichung 3) ist die Stromleistung infolge des Pinch-Widerstands begrenzt.

Aus GB-A-1319037 ist ein Transistor mit hoher Rückwärtsstromverstärkung bekannt, der einen geringen Verluststrom und hohe Schaltgeschwindigkeit haben soll, und zwar durch von dem Kollektor reinjizierte Ladungsträger. Ein zusätzlicher Emitter "sammelt" dabei vom Kollektor reinjizierte Ladungsträger und führt diese zur Basis zurück.

Aus IEEE Transactions on Electron Devices, Vol. ED-23, Nr. 8, Seiten 883 bis 887 (1976) ist ein Thyristor bekannt, bei dem n-dotierte Diffusionsgebiete neben der n-Emitterzone in der p-Basiszone vorgesehen sind, um die Ausschaltzeit zu verkürzen.

Der vorliegenden Erfindung liegt die Aufgabe zugrunde, bei einem Schalttransistor der im Oberbegriff des Patentanspruchs 1 genannten Art eine Absaugelektrode zur Verkürzung der Ausschaltzeit mit größtmöglichem Wirkungsgrad bei geringstem Flächenbedarf anzugeben.

Diese Aufgabe wird durch einen Schalttransistor mit den Merkmalen des Patentanspruchs 1 gelöst.

Ausgestaltungen und Vorteile der Erfindung sind in den Unteransprüchen, der Beschreibung und der Zeichnung angegeben.

Die Wirkungsweise eines zusätzlichen Diffusionsgebietes bei Halbleiterbauelementen, insbesondere bei Schalttransistoren, ist bereits in den Veröffentlichungen 1) und 2) beschrieben.

Ein Ausführungsbeispiel der Erfindung ist in der Zeichnung dargestellt.
Figur 1 zeigt die Realisierung einer Absaugelektrode nach der Erfindung bei einem Schalttransistor in der Draufsicht auf die Oberfläche des Schalttranistors.
Figur 2 zeigt einen Schnitt durch einen Schalttransistor nach Figur 1.

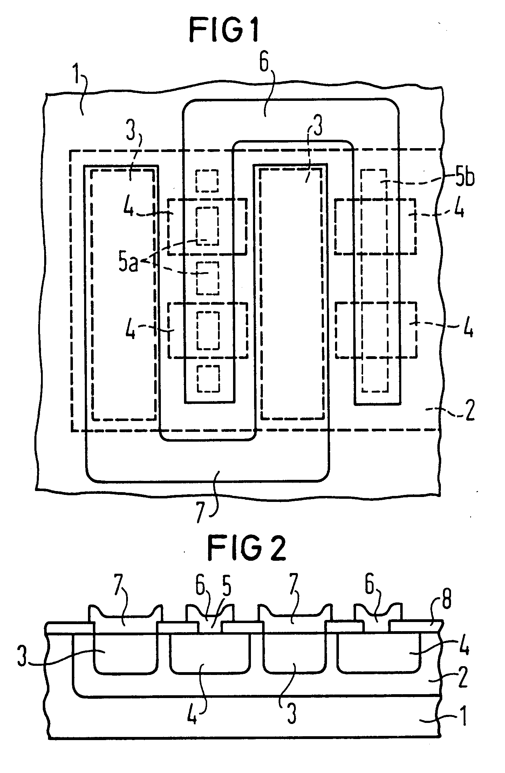

Figuren 1 und 2 zeigen schematisch das Prinzip einer Absaugelektrode. In einem Kollektorgebiet 1 befindet sich ein Basisgebiet 2. Im Basisgebiet 2 befindet sich ein Emittergebiet 3. Im Basisbereich 2 sind Diffusionsbereiche 4 angeordnet. Diese Diffusionsbereiche 4 gehören zur Absaugelektrode. Diese Diffusionsbereiche 4 besitzen die gleiche Art der Dotierung wie der Emitterbereich 3. Die Diffusionsbereiche 4 können daher gleichzeitig mit dem Emitterbereich 3 hergestellt werden. Zur Herstellung der Diffusionsbereiche 4 werden daher keine zusätzlichen Technologieschritte benötigt.

Zur Kontaktierung der Diffusionsbereiche 4 und des Basisbereichs 2 können unterschiedliche Kontaktfenster 5a und 5b vorgesehen werden. Die Kontaktfenster 5a bilden getrennte Kontaktfenster für die Basismetallisierung und für die Metallisierung der Absaugelektrode. Das Kontaktfenster 5b bildet ein gemeinsames Kontaktfenster für die Basismetallisierung und für die Metallisierung der Absaugelektrode.

Basismetallisierung und Metallisierung der Absaugelektrode können zu einer einzelnen Basiselektrode 6 zusammengefaßt werden. Die Emittermetallisierung 7 kann kammartig in die Metallisierung der Basiselektrode 6 eingreifen.

Zwischen den Metallisierungen 6, 7 und der Halbleiteroberfläche ist eine isolierende Schicht 8 vorgesehen, die aus Siliziumdioxid und/oder Siliziumnitrid bestehen kann.

Die zusätzlichen Diffusionsgebiete 4 im Bereich der Basis 2, welche die Absaugelektrode bilden, können über einzelne Kontaktfenster 5a oder über ein gemeinsames Basis-Absaugelektroden-Kontaktfenster 5b mit der Basiselektrode 6 elektrisch kurzgeschlossen werden.

Sind nur einzelne Kontaktfenster 5a vorhanden, so zeichnet sich diese Realisierung dadurch aus, daß im Bereich der Absaugelektrode ein Kontaktfenster für den Basiskurzschluß derart geöffnet wird, daß kein Metall direkt auf dem pn-Übergang zwischen Basisbereich 2 und Diffusionsbereichen 4 der Absaugelektrode liegt. Die einzelnen Kontaktfenster 5a bieten den Vorteil, daß sich die Diffusionsspannung auch im Bereich der Oberfläche des Halbleiterbauelements ohne Störung durch eine Metallüberlappung ausbilden kann. Im Bereich der Oberfläche des Halbleiterbauelements ist aufgrund des Dotierprofils die mögliche Diffusionsspannung am größten. Einzelne Kontaktfenster 5a erlauben jedoch nur kleine Basisanschlußfenster, was zu einer Erhöhung des Basis-Widerstands führt.

Wenn Absaugelektroden und Basisanschluß ein gemeinsames Kontaktfenster 5b haben, liegt der größte Teil der Absaugelektrode außerhalb des Kontaktfensters 5b. Ein gemeinsames Basis-Absaugelektroden-Kontaktfenster 5b hat den Vorteil, daß der Basiskontaktbereich im Vergleich zu einer Realisierung mit einzelnen Kontaktfenstern 5a groß ist, was sich günstig in Richtung auf einen niedrigen Basiswiderstand auswirkt. Auch wenn bei Verwendung eines gemeinsamen Basis-Absaugelektroden-Kontaktfensters 5b in denjenigen Bereichen, in denen das Metall der Basiselektrode 6 direkt auf dem pn-Übergang von Absaugelektrode und Basisbereich 2 liegt, die Absaugung der Minoritätsladungsträger aufgrund des überlappenden Metalls gestört und die Absaugwirkung ein wenig eingeschränkt ist, ist die Schaltzeitverkürzung auch bei Verwendung eines gemeinsamen Basis-Absaugelektroden-Kontaktfensters 5b im Vergleich zum Stand der Technik immer noch erheblich.

Sowohl bei Verwendung von einzelnen Kontaktfenstern 5a als auch bei Verwendung eines gemeinsamen Kontaktfensters 5b benötigt die Absaugelektrode keine zusätzliche Fläche. Trotz des Vorhandenseins der Absaugelektrode kann der Abstand zwischen der Basismetallisierung 6 und der Emittermetallisierung 7 unverändert im Vergleich mit einem Halbleiterbauelement ohne Absaugelektrode bleiben. Zwischen den Diffusionsgebieten 4 für die Absaugelektrode und dem Emitterbereich 3 reicht ein geringer Abstand, um einen Kurzschluß zwischen diesen Bereichen zu vermeiden.

Anordnung und Dimensionierung von Diffusionsbereichen 4 der Absaugelektrode und Kontaktfenstern 5a bzw. 5b können derart gewählt werden, daß je nach Anwendungsfall möglichst kleiner Basiswiderstand und möglichst kurze Ausschaltzeiten erzielt werden.

## Patentansprüche

1. Schalttransistor mit einem ersten Halbleiterbereich (2) einer Dotierungsart, wobei der erste Halbleiterbereich ein Basisgebict ist, mit wenigstens einem zweiten Halbleiterbereich (3) der anderen Dotierungsart innerhalb des ersten Halbleiterbereichs (2), mit wenigstens einem dritten Halbleiterbereich (4) der anderen Dotierungsart, der innerhalb des ersten Halbleiterbereichs (2) und außerhalb des wenigstens einen zweiten Halbleiterbereichs (3) liegt, so daß es einen pn-Übergang zwischen dem ersten Halbleiterbereich (2) und dem wenigstens einen dritten Halbleiterbereich (4) gibt, mit einer Absaugelektrode zur Verkürzung der Ausschaltzeit, **dadurch gekennzeichnet**, daß die Absaugelektrode einen metallischen Kurzschluß (6) zwischen dem wenigstens einen dritten Halbleiterbereich (4) und dem ersten Halbleiterbereich (2) bildet, daß wenigstens ein Teil des pn-Übergangs frei von Metallisierung ist, daß sich im Bereich wenigstens eines dritten Halbleiterbereichs (4) wenigstens ein Kontaktfenster (5) befindet, daß wenigstens ein dritter Halbleiterbereich (4) und der erste Halbleiterbereich (2) wenigstens ein gemeinsames Kontaktfenster (5) haben und daß der größere Teil dieses wenigstens einen dritten Halbleiterbereichs (4) außerhalb dieses wenigstens einen Kontaktfensters (5) liegt.

2. Schalttransistor nach Anspruch 1, **dadurch gekennzeichnet**, daß innerhalb wenigstens eines dritten Halbleiterbereichs (4) mindestens ein Kontaktfenster (5a) liegt, so daß der pn-Übergang zwischen diesem mindestens einen dritten Halbleiterbereich (4) und dem ersten Halbleiterbereich (2) frei von Metallisierung ist.

3. Schalttransistor nach einem der Ansprüche 1 oder 2, **dadurch gekennzeichnet**, daß der Abstand zwischen dem dritten Halbleiterbereich (4) und dem zweiten Halbleiterbereich (3) gerade so groß ist, daß ein Kurzschluß zwischen diesen beiden Bereichen vermieden wird.

## Claims

1. Switching transistor having a first semiconductor area (2) of one type of doping, the first semiconductor area being a base region, having at least a second semiconductor area (3) of the other type of doping within the first semiconductor area (2), having at least a third semiconductor area (4) of the other type of doping which is located within the first semiconductor area (2) and outside the at least one second semiconductor area (3) so that there is a pn junction between the first semiconductor area (2) and the at least one third semiconductor area (4), comprising an extraction electrode for shortening the turn-off time, characterized in that the extraction electrode forms a metallic short circuit (6) between the at least one third semiconductor area (4) and the first semiconductor area (2), in that at least a part of the pn junction is free of metallization, in that at least one contact window (5) is located in the area of at least one third semiconductor area (4), in that at least one third semiconductor area (4) and the first semiconductor area (2) have at least one common contact window (5), and in that the greater proportion of this at least one third semiconductor area (4) is located outside this at least one contact window (5).

2. Switching transistor according to Claim 1, characterized in that at least one contact window (5a) is located within at least one third semiconductor area (4) so that the pn junction between this at least one third semiconductor area (4) and the first semiconductor area (2) is free of metallization.

3. Switching transistor according to one of Claims 1 and 2, characterized in that the distance between the third semiconductor area (4) and the second semiconductor area (3) is just large enough for a short circuit between these two areas to be avoided.

## Revendications

1. Transistor de commutation comportant une première zone semiconductrice (2) d'un type de dopage, la première zone semiconductrice étant une région de base, au moins une deuxième zone semiconductrice (3) de l'autre type de dopage disposée à l'intérieur de la première zone semiconductrice (2), au moins une troisième zone semiconductrice (4) de l'autre type de dopage, qui est située à l'intérieur de la première zone semiconductrice (2) et à l'extérieur d'au moins une deuxième zone semiconductrice (3), en sorte qu'il se forme une jonction pn entre la première zone semiconductrice (2) et la ou les troisièmes zones semiconductrices (4), et une électrode d'extraction pour réduire le temps de mise à l'état bloqué, caractérisé par le fait que l'électrode d'extraction forme un court-circuit métallique (6) entre la ou les troisièmes zones semiconductrices (4) et la première zone semiconductrice (2), qu'au moins une partie de la jonction pn ne comporte pas de métallisation, qu'au moins une fenêtre de contact (5) est située au niveau d'au moins une troisième zone semiconductrice (4), qu'au moins une troisième zone semiconductrice (4) et la première zone semiconductrice (2) comportent au moins une fenêtre de contact commune (5), et que la majeure partie de cette ou de ces troisièmes zones semiconductricces (4) est située à l'extérieur de cette ou de fenêtres de contact (5).

2. Transistor de commutation suivant la revendication 1, caractérisé par le fait qu'au moins une fenêtre de contact (5a) est située à l'intérieur d'au moins une troisième zone semiconductrice (4), en sorte que la jonction pn entre cette ou ces troisièmes zones semiconductrices (4) et la première zone semiconductrice (2) ne comporte pas de métallisation.

3. Transistor de commutation suivant l'une des revendications 1 ou 2, caractérisé par le fait que la distance entre la troisième zone semiconductrice (4) et la deuxième zone semiconductrice (3) est précisément si grande qu'un court-circuit est évité entre ces deux zones.
